# FASCICULE DE BREVET EUROPEEN

(11) **EP 0 926 935 B1**
(45) Date de publication et mention de la délivrance du brevet: **31.08.2005**
(21) Numéro de dépôt: 98403209.4
(22) Date de dépôt: 18.12.1998
(51) Int. Cl.: H05K 3/40, H05K 1/14

(54) **Dispositif et procédé d'interconnexion entre deux dispositifs électroniques**
Vorrichtung und Verfahren zur Verbindung zwischen zwei elektronischen Anordnungen
Device and process for interconnecting between two electronic devices

(30) Priorité: 23.12.1997 FR 9716300
(43) Date de publication de la demande: 30.06.1999
(73) Titulaire: AIRBUS France, 31060 Toulouse (FR)
(72) Inventeur: Bedos, Jean-Philippe, 31200 Toulouse (FR); Sune, Gérard, 31650 Saint-Orens (FR)
(74) Mandataire: Bonnetat, Christian

(56) Documents cités:
- EP-A- 0 653 905
- DE-A- 2 338 647
- DE-A- 3 705 828
- PATENT ABSTRACTS OF JAPAN vol. 18, no. 340 (E-1569), 27 juin 1994 & JP 06 085465 A (TDK CORP), 25 mars 1994
- PATENT ABSTRACTS OF JAPAN vol. 18, no. 590 (E-1628), 10 novembre 1994 & JP 06 224537 A (KAIJO CORP), 12 août 1994
- PATENT ABSTRACTS OF JAPAN vol. 13, no. 123 (E-733), 27 mars 1989 & JP 63 291490 A (IBIDEN CO), 29 novembre 1988
- PATENT ABSTRACTS OF JAPAN vol. 96, no. 10, 31 octobre 1996 & JP 08 167438 A (SANKYO KASEI CO), 25 juin 1996
- PATENT ABSTRACTS OF JAPAN vol. 15, no. 50 (E-1030), 6 février 1991 & JP 02 281648 A (TDK CORP), 19 novembre 1990

## Description

La présente invention se rapporte à la connexion d'un dispositif électronique, tel qu'un circuit intégré (par exemple un microprocesseur), sur un autre dispositif électronique, tel qu'un circuit imprimé, une carte mère ou analogue.

On sait que, pour réaliser une telle connexion, lesdits dispositifs électroniques sont pourvus de pluralités de contacts respectifs, positionnés selon des dispositions semblables, de sorte que, lorsque le premier dispositif électronique est mis en place sur le second, chacun de ses contacts est en appui contre un contact dudit second dispositif électronique.

On sait également qu'il peut être nécessaire, dans une telle connexion, de modifier un signal électrique, une tension d'alimentation, l'affectation ou la correspondance des contacts respectifs, etc ... entre lesdits dispositifs électroniques, ou bien encore de modifier ledit premier dispositif électronique en évitant de modifier le second.

Par le document JP-A-06 224 537 et aussi, par exemple par les documents EP-A-0 641 046 et FR-A-2 722 334, on connaît déjà un dispositif d'interconnexion interposé entre lesdits premier et second dispositifs électroniques et apte à apporter les modifications nécessaires à la connexion entre ces derniers. Un tel dispositif d'interconnexion comporte une plaquette de circuit imprimé, portant éventuellement des composants actifs, comprenant une première et une seconde faces opposées limitées par un chant périphérique et pourvues respectivement de jeux de premiers et seconds contacts périphériques interconnectés, les dispositions des premiers et seconds contacts périphériques desdites première et seconde faces correspondant respectivement à celles des contacts desdits premier et second dispositifs électroniques. Ainsi, un contact dudit premier dispositif électronique peut être électriquement relié à un contact dudit second dispositif électronique, par l'intermédiaire d'un premier contact de ladite première face et d'un second contact de ladite seconde face, interconnectés par ladite plaquette de circuit imprimé.

Ainsi, dans une telle connexion, ledit dispositif d'interconnexion porte ledit premier dispositif électronique et est lui-même porté par ledit second dispositif électronique. Il en résulte quelques conséquences sur la fixation desdits dispositifs entre eux. En général, la fixation dudit premier dispositif électronique sur ledit dispositif d'interconnexion ne soulève que peu de difficulté, car la première face de la plaquette du dispositif d'interconnexion est apparente et, de plus, ledit premier dispositif comporte généralement des languettes (pattes) de connexion périphériques. En revanche, la fixation de la plaquette dudit dispositif d'interconnexion sur le second dispositif électronique est malaisée, car ladite plaquette cache les contacts dudit second dispositif électronique. Cela interdit donc de réaliser lesdits seconds contacts périphériques du dispositif d'interconnexion, ainsi que ceux du second dispositif électronique, sous la forme de plages conductrices métallisées. Dans la pratique, on est obligé de réaliser les seconds contacts périphériques dudit dispositif d'interconnexion sous la forme de broches mâle et les contacts dudit second dispositif électronique sous la forme de broches femelle, coopérantes.

Il est bien connu que de tels connecteurs à broches mâle et femelle coopérantes présentent de nombreux inconvénients. Non seulement ils sont de coût élevé, mais encore ils nécessitent une grande précision de la présentation des broches mâle vis-à-vis de broches femelle, ainsi qu'une extrême rectitude et un excellent parallélisme desdites broches mâle. De plus, ils présentent un encombrement en hauteur important et ils ne permettent pas une grande densité de contacts.

La présente invention a pour objet de remédier à ces inconvénients et d'éviter l'utilisation de connecteurs à broches mâle et femelle avec les dispositifs d'interconnexion mentionnés ci-dessus. Quoique non exclusivement, elle est particulièrement appropriée aux systèmes électroniques de technologie CMS (Composants Montés en Surface), mise en oeuvre lorsque le volume disponible est faible. Il est tout spécialement avantageux de l'utiliser lorsque le premier dispositif électronique subit des modifications et que l'on veut éviter de changer ledit second dispositif électronique.

A cette fin, selon l'invention (cf. la revendication 1), le dispositif d'interconnexion entre deux dispositifs électroniques, ce dispositif d'interconnexion portant l'un desdits dispositifs électroniques et étant porté par l'autre de ceux-ci, et comportant une plaquette de circuit imprimé comprenant deux faces opposées limitées par un chant périphérique, la première desdites faces comportant un jeu de premiers contacts périphériques aptes à coopérer avec un ensemble de contacts périphériques prévus sur ledit dispositif électronique porté par ledit dispositif d'interconnexion, tandis que la seconde desdites faces comporte un jeu de seconds contacts périphériques aptes à coopérer avec un ensemble de contacts prévus sur ledit dispositif électronique portant ledit dispositif d'interconnexion, lesdits premiers et seconds contacts périphériques portés par lesdites faces opposées de ladite plaquette étant interconnectés, est remarquable :
- en ce que lesdits seconds contacts périphériques, aptes à coopérer avec les contacts du dispositif électronique portant ledit dispositif d'interconnexion, sont constitués par des plages électriquement conductrices portées par ladite seconde face ;
- en ce que, à chacun desdits seconds contacts périphériques, est associée une rainure à paroi conductrice, pratiquée dans ledit chant de la plaquette et en liaison électrique avec ledit second contact associé ;
- en ce que lesdites rainures à paroi conductrice sont électriquement isolées desdits premiers contacts périphériques de ladite première face ;
- en ce que chacun desdits seconds contacts périphériques est appliqué contre le contact correspondant du dispositif électronique portant ; et
- en ce que la fixation dudit dispositif d'interconnexion sur ledit dispositif électronique portant ainsi que la conduction électrique entre chacun desdits seconds contacts périphériques et le contact correspondant dudit dispositif électronique portant sont obtenues par l'intermédiaire desdites rainures à paroi conductrice.

Ainsi, chaque rainure à paroi conductrice est électriquement reliée à un second contact du dispositif d'interconnexion et peut être utilisée pour relier électriquement ledit second contact au contact correspondant du dispositif électronique portant. De plus, chaque rainure reste constamment visible sur le chant de la plaquette et permet de localiser ledit second contact caché par ledit dispositif d'interconnexion. Lesdits seconds contacts peuvent donc être réalisés sous la forme de plages conductrices.

On remarquera que le document japonais 06-085465 au nom de TDK Corp., publié le 25 mars 1994, décrit un dispositif de connexion entre des électrodes superficielles latérales et un circuit imprimé interne. Un tel dispositif n'est pas, à proprement parler, un dispositif d'interconnexion du type concerné par la présente invention. De plus, dans ce dispositif antérieur, les plages conductrices 7, portées par la grande face 2B du dispositif et solidaires des rainures conductrices latérales 3, ne sont pas destinées à être appliquées contre des contacts du dispositif.

Le procédé d'interconnexion de deux dispositifs électroniques au moyen d'un dispositif d'interconnexion peut donc résider, conformément à la présente invention (cf. la revendication 6):
- en ce qu'on réalise lesdits seconds contacts périphériques du dispositif d'interconnexion et lesdits contacts du dispositif électronique portant ce dernier sous la forme de plages conductrices, lesdits contacts dudit dispositif électronique portant faisant saillie à l'extérieur du contour de ladite plaquette, lorsque celle-ci est en position sur ledit dispositif électronique portant ;
- en ce qu'on forme, dans le chant de ladite plaquette, des rainures à paroi conductrice, donc chacune d'elles est associée et en liaison électrique avec un desdits seconds contacts périphériques, mais est électriquement isolée desdits premiers contacts périphériques ;
- en ce qu'on applique ladite seconde face de ladite plaquette contre ledit dispositif électronique portant, de façon que chacun desdits seconds contacts périphériques soit appliqué sur un contact dudit dispositif électronique portant ; et
- en ce qu'on fixe ledit dispositif d'interconnexion sur ledit dispositif électronique portant par des doses de soudure assurant les connexions électriques respectives entre les parois conductrices des rainures et les parties saillantes desdits contacts du dispositif électronique portant.

De préférence, lesdites rainures à paroi conductrice présentent une direction au moins sensiblement orthogonale aux faces de ladite plaquette et elles sont isolées desdits premiers contacts périphériques du dispositif d'interconnexion par un chanfrein. Elles peuvent présenter une forme au moins approximativement hémicylindrique.

Aussi, pour réaliser un tel dispositif d'interconnexion, on peut procéder de la façon suivante (cf. la revendication 7):
- sur lesdites première et seconde faces de ladite plaquette, on réalise respectivement lesdits premiers et seconds contacts périphériques sous la forme de plages électriquement conductrices ;
- dans chacun desdits seconds contacts périphériques, on perce un trou cylindrique traversant ladite plaquette ;
- on revêt la paroi desdits trous cylindriques d'une couche électriquement conductrice ;
- on élimine la bordure périphérique de ladite plaquette, de façon que chacun des trous à paroi électriquement conductrice devienne une rainure à paroi conductrice de forme au moins approximativement hémicylindrique ; et
- on pratique un chanfrein à la périphérie de ladite plaquette, entre ledit chant et ladite première face, pour éliminer toute possibilité de contact entre lesdites rainures à paroi conductrice et lesdits premiers contacts périphériques.

Avantageusement, ladite plaquette du dispositif d'interconnexion comprend un circuit imprimé multicouche.

Les figures du dessin annexé feront bien comprendre comment l'invention peut être réalisée. Sur ces figures, des références identiques désignent des éléments semblables.
La figure 1 est une vue, en perspective éclatée partielle, d'un exemple de réalisation de l'interconnexion conforme à la présente invention.
La figure 2 est une vue en coupe partielle du dispositif d'interconnexion conforme à la présente invention, selon la ligne de coupe II-II de la figure 1.
Les figures 3, 4 et 5 sont respectivement des vues du dessus, de face et du dessous de la portion du dispositif montrée par la figure 2.
La figure 6 illustre, en coupe transversale partielle, la connexion du dispositif conforme à la présente invention sur une carte de circuit imprimé.
La figure 7 correspond à la vue de dessus de la connexion de la figure 6.
La figure 8 illustre, en coupe transversale partielle, la connexion du dispositif conforme à la présente invention entre ladite carte de circuit imprimé et un composant électronique.

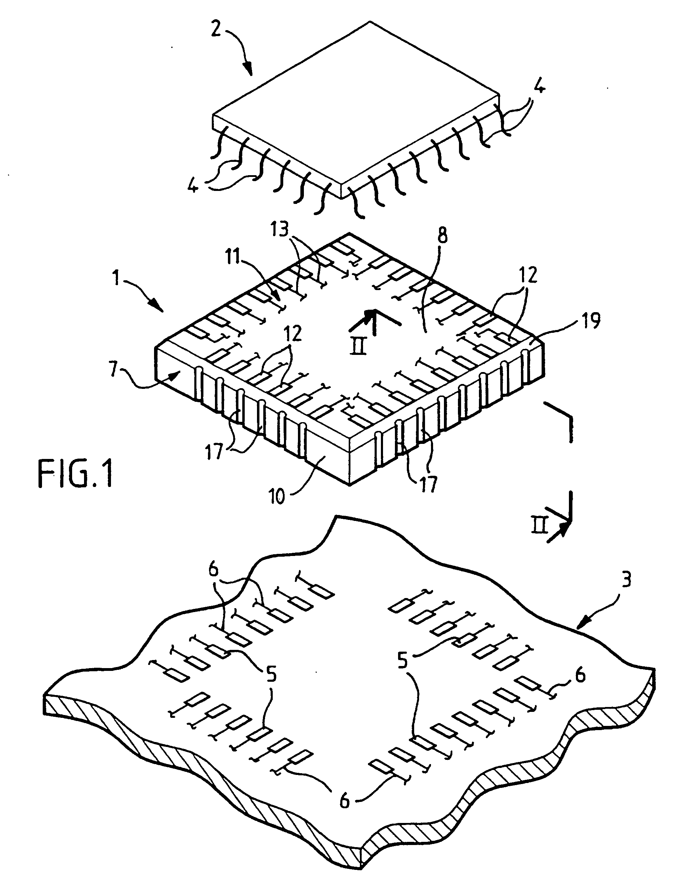

Sur la figure 1, on a représenté schématiquement en perspective un dispositif d'interconnexion 1 conforme à la présente invention, destiné à être interposé entre un composant électronique 2, par exemple un microprocesseur, et une carte mère 3.

Le composant 2 comporte un ensemble de contacts latéraux périphériques 4, par exemple constitués par des pattes ou languettes métalliques. La carte mère 3 comporte également un ensemble de contacts 5, réalisés sous la forme de plages métalliques à la surface de ladite carte mère 3. Chaque contact 5 est relié à un conducteur 6, partiellement représenté.

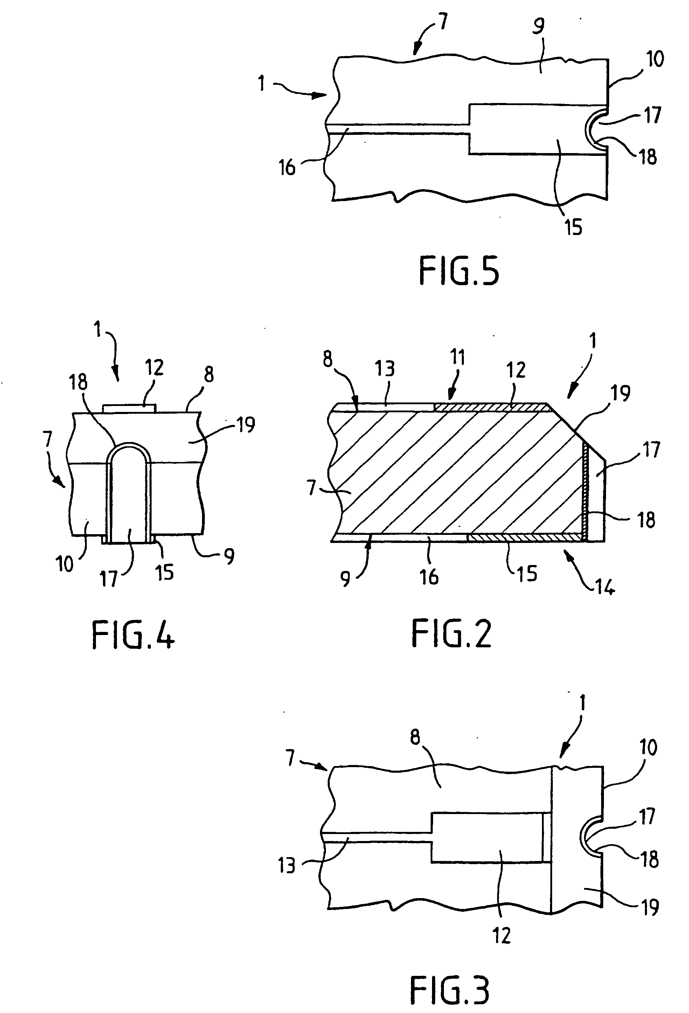

Comme le montrent également les figures 2 à 5, le dispositif d'interconnexion 1 conforme à la présente invention comporte une plaquette isolante de circuit imprimé 7, avantageusement de type à circuit imprimé multicouche, comprenant une face supérieure 8 et une face inférieure 9 limitées par un chant périphérique 10.

La face supérieure 8 de la plaquette 7 porte un jeu 11 de contacts 12, réalisés sous la forme de plages conductrices et reliés à des conducteurs 13, partiellement représentés. Les contacts 12 sont disposés en correspondance avec les contacts 4 du composant 2.

La face inférieure 9 de la plaquette 7 porte un jeu 14 de contacts 15, réalisés sous la forme de plages conductrices et reliés à des conducteurs 16, partiellement représentés. Les contacts 15 sont disposés en correspondance avec les contacts 5 de la carte mère 3.

Grâce aux conducteurs 13 et 16, qui font avantageusement partie d'un circuit imprimé multicouche et qui traversent la plaquette 7 de façon usuelle non représentée, chaque contact 12 est relié électriquement à au moins un contact 15 et réciproquement, éventuellement avec interposition de composants électroniques non représentés.

Par ailleurs, dans le chant 10 de la plaquette 7 sont disposées des rainures hémicylindriques 17, dont la paroi est revêtue d'une couche métallique 18 et dont la direction générale est orthogonale aux faces 8 et 9 de la plaquette 7. Chaque rainure 17 est associée à un contact 15 du jeu 14 de la face inférieure 9, avec sa couche métallique 18 électriquement reliée au contact 15 correspondant.

Les contacts 12 de la face supérieure 8 sont isolés électriquement des rainures métallisées 17, grâce à un chanfrein périphérique 19 mordant à la fois sur la face supérieure 8 et sur le chant périphérique 10.

On remarquera que, sur la figure 1, on n'a représenté qu'un nombre limité de contacts 4, 5, 12 et de rainures métallisées 17, pour des raisons de clarté du dessin, mais que, dans la réalité, ces contacts et rainures peuvent être beaucoup plus nombreux et plus denses.

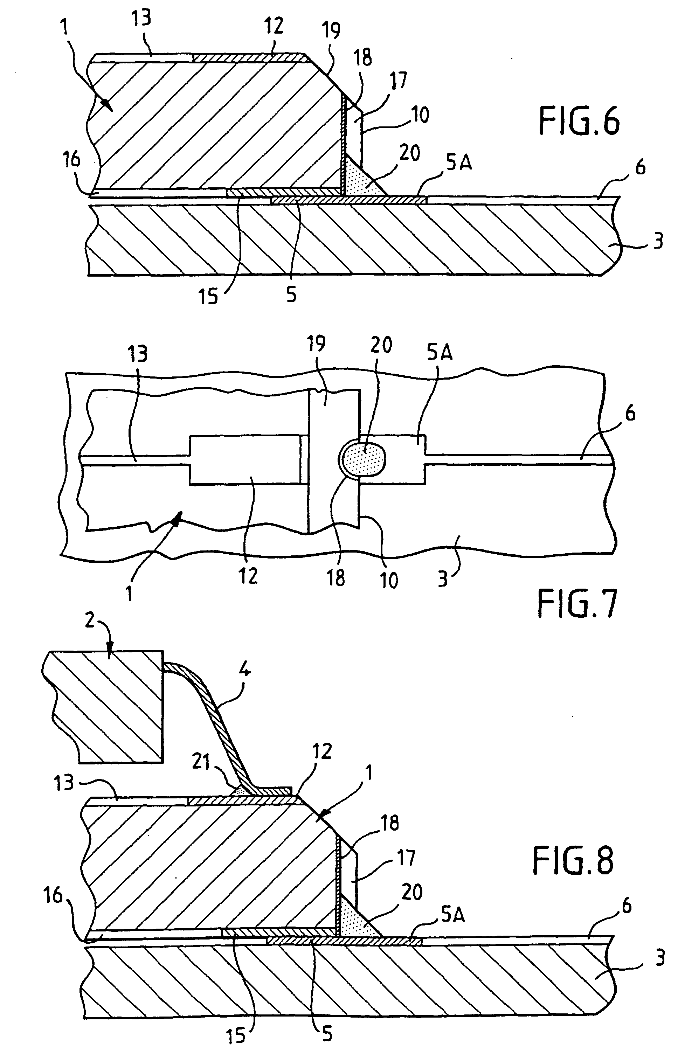

De ce qui précède, on comprendra aisément que, comme le montrent les figures 6 et 7, il est possible d'appliquer le dispositif d'interconnexion 1 sur la carte mère 3 de façon que chacun des couples contact 15 - rainure métallisée 17 dudit dispositif d'interconnexion se trouve à l'aplomb d'un contact 5 de ladite carte mère 3 et repose sur celui-ci. Des doses de soudure ou brasure 20, logées en partie dans les rainures métallisées 17 et soudées sur les parties 5A des contacts 5 débordant à l'extérieur du dispositif d'interconnexion 1, permettent de fixer le dispositif d'interconnexion 1 sur la carte mère 3 et d'assurer d'excellentes liaisons électriques entre les éléments de chaque triplet contact 5 - contact 15 - rainure métallisée 17.

Bien entendu, antérieurement ou postérieurement à la fixation du dispositif d'interconnexion 1 sur la carte mère 3, le composant électronique 2 peut être fixé et relié électriquement audit dispositif d'interconnexion 1, en fixant chacun de ses contacts 4 sur le contact 12 de la face supérieure 8 par une dose de soudure 21 (voir la figure 8).

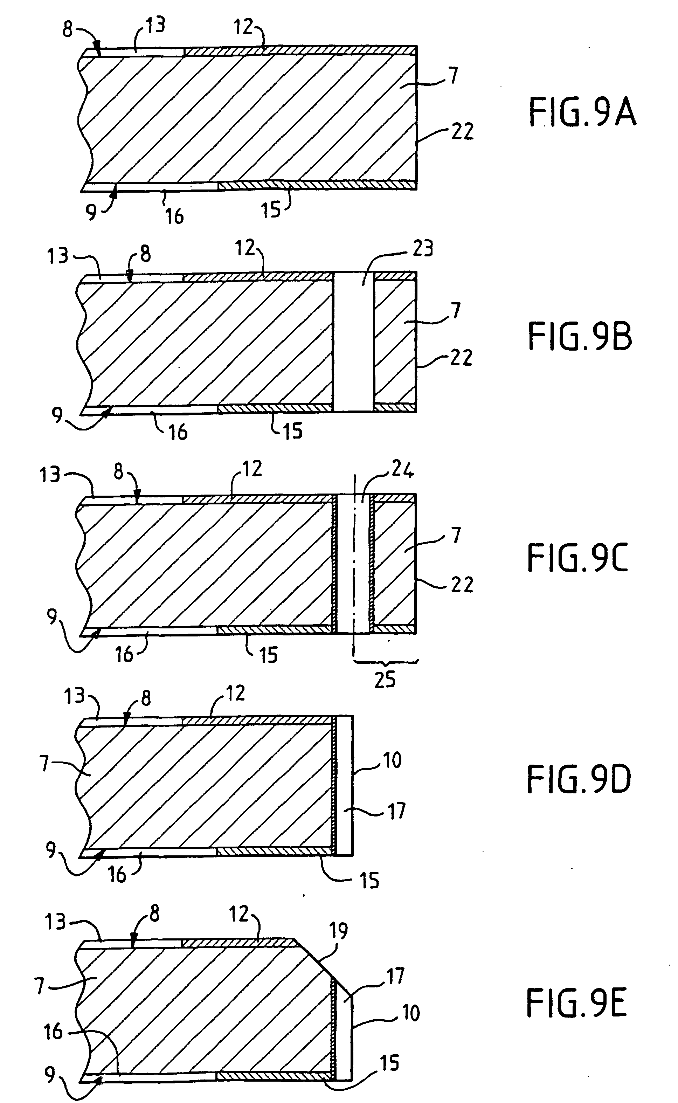

Pour obtenir le dispositif d'interconnexion 1 conforme à la présente invention et décrit ci-dessus, on peut opérer de la façon suivante :
a) sur une plaquette isolante 7, comportant une face supérieure 8 et une face inférieure 9 limitées par un chant périphérique 22, on commence par former, par les techniques usuelles connues des circuits imprimés, les jeux des contacts 12 et 15 et les réseaux des conducteurs 13 et 16 (voir la figure 9A) ;
b) on pratique ensuite à travers chacun desdits contacts 15, un trou cylindrique 23, au voisinage du chant périphérique 22 (voir la figure 9B) ;
c) de façon usuelle dans la technique des circuits imprimés, les trous cylindriques 23 sont métallisés, c'est-à-dire revêtus d'une couche métallique 24 sur leur paroi cylindrique (voir la figure 9C) ;
d) la bordure 25 de ladite plaquette 7, comprise entre les axes des trous métallisés 23 et le chant périphérique 22 est alors éliminé, par exemple par sciage ou par détourage, pour former les rainures métallisées 17 et le chant 10 (voir les figures 9C et 9D) ;
e) enfin, le chanfrein 19 est usiné à cheval sur la face supérieure 8 et sur le chant 10, pour assurer l'isolation électrique entre les contacts 12 de la face supérieure 8 et les rainures métallisées 17 (voir la figure 9E).

## Revendications

1. Dispositif d'interconnexion (1) entre un premier dispositif électronique (2), tel qu'un microprocesseur, et un second dispositif électronique (3), tel qu'une carte mère, ce dispositif d'interconnexion (1) portant l'un (2) desdits dispositifs électroniques et étant porté par l'autre (3) de ceux-ci, lesdits premier et second dispositifs électroniques (2 et 3) étant pourvus de pluralités de contacts respectifs (4 ou 5) positionnés selon des dispositions semblables, de sorte que, lorsque ledit premier dispositif électronique (2) est mis en place sur le second (3), chacun de ses contacts (4), qui sont périphériques, est en appui contre un contact (5) dudit second dispositif électronique (3), ledit dispositif d'interconnexion (1) étant apte à permettre de modifier ledit premier dispositif électronique (2) en évitant de modifier ledit second dispositif électronique (3) et comportant une plaquette de circuit imprimé (7) comprenant deux faces opposées (8 et 9) limitées par un chant périphérique (10), la première (8) desdites faces comportant une pluralité (11) de premiers contacts périphériques (12) aptes à coopérer respectivement avec lesdits contacts périphériques (4) dudit dispositif électronique (2), tandis que la seconde (9) desdites faces comporte une pluralité (14) de seconds contacts périphériques (15) aptes à coopérer respectivement avec lesdits contacts (5) prévus sur ledit second dispositif électronique (3), lesdits premiers et seconds contacts périphériques (12 et 15) portés par lesdites faces opposées (8 et 9) de ladite plaquette (7) étant interconnectés:
- lesdits seconds contacts périphériques (15), aptes à coopérer avec les contacts (5) dudit second dispositif électronique (3), sont constitués par des plages électriquement conductrices portées par ladite seconde face (9) ;
- à chacun desdits seconds contacts périphériques (15) est associée une rainure (17) à paroi conductrice (18), pratiquée dans ledit chant (10) de la plaquette (7) et en liaison électrique avec ledit second contact (15) associé ;
- lesdites rainures (17) à paroi conductrice (18) sont électriquement isolées desdits premiers contacts périphériques (12) de ladite première face (8) ;
- chacun desdits seconds contacts périphériques (15) est appliqué contre le contact correspondant (5) dudit second dispositif électronique (3) ; et
- la fixation dudit dispositif d'interconnexion (1) sur ledit second dispositif électronique (3) ainsi que la conduction électrique entre chacun desdits seconds contacts périphériques (15) et le contact correspondant (5) dudit second dispositif électronique (3) sont obtenues par l'intermédiaire desdites rainures (17) à paroi conductrice (18).

2. Dispositif d'interconnexion selon la revendication 1,
**caractérisé en ce que** lesdites rainures à paroi conductrice (17) présentent une direction au moins sensiblement orthogonale auxdites faces (8 et 9) de ladite plaquette (7).

3. Dispositif d'interconnexion selon l'une des revendications 1 ou 2,
**caractérisé en ce que** lesdites rainures à paroi conductrice (17) sont électriquement isolées desdits premiers contacts périphériques (12) par un chanfrein périphérique (19).

4. Dispositif d'interconnexion selon l'une des revendications 1 à 3,
**caractérisé en ce que** chacune desdites rainures à paroi conductrice (17) présente une forme au moins approximativement hémicylindrique.

5. Dispositif d'interconnexion selon l'une des revendications 1 à 4,
**caractérisé en ce que** ladite plaquette (7) comprend un circuit imprimé multicouche.

6. Procédé d'interconnexion entre un premier dispositif électronique (2), tel qu'un microprocesseur, et un second dispositif électronique (3), tel qu'une carte mère, au moyen d'un dispositif d'interconnexion (1) portant l'un (2) desdits dispositifs électroniques et étant porté par l'autre de ceux-ci, lesdits premier et second dispositifs électroniques (2 et 3) étant pourvus de pluralités de contacts respectifs (4 ou 5) positionnés selon des dispositions semblables, de sorte que, lorsque ledit premier dispositif électronique (2) est mis en place sur le second (3), chacun de ses contacts (4), qui sont périphériques, est en appui contre un contact (5) dudit second dispositif électronique (3), ledit dispositif d'interconnexion (1) étant apte à permettre de modifier ledit premier dispositif électronique (2) en évitant de modifier ledit second dispositif électronique (3) et comportant une plaquette de circuit imprimé (7) comprenant deux faces opposées (8 et 9) limitées par un chant périphérique (10), la première (8) desdites faces comportant une pluralité (11) de premiers contacts périphériques (12) aptes à coopérer respectivement avec lesdits contacts périphériques (4) dudit premier dispositif électronique (2), tandis que la seconde (9) desdites faces comporte une pluralité (14) de seconds contacts périphériques (15) aptes à coopérer respectivement avec lesdits contacts (5) prévus sur ledit second dispositif électronique (3), lesdits premiers et seconds contacts périphériques (12 et 15) portés par lesdites faces opposées (8 et 9) de ladite plaquette (7) étant interconnectés,
**caractérisé :**
- **en ce qu'**on réalise lesdits seconds contacts périphériques (15) du dispositif d'interconnexion (1) et lesdits contacts (5) dudit second dispositif électronique (3) sous la forme de plages conductrices, lesdits contacts (5) dudit second dispositif électronique (3) faisant saillie (5A) à l'extérieur du contour de ladite plaquette (7), lorsque celle-ci est en position sur ledit second dispositif électronique (3) ;
- **en ce qu'**on forme, dans le chant (10) de ladite plaquette (7), des rainures (17) à paroi conductrice (18), donc chacune d'elles est associée et en liaison électrique avec un desdits seconds contacts périphériques (15), mais est électriquement isolée desdits premiers contacts périphériques (12) ;
- **en ce qu'**on applique ladite seconde face (9) de ladite plaquette (7) contre ledit second dispositif électronique (3), de façon que chacun desdits seconds contacts périphériques (15) soit appliqué sur un contact (5) dudit second dispositif électronique (3) ; et
- **en ce qu'**on fixe ledit dispositif d'interconnexion (1) sur ledit second dispositif électronique (3) par des doses de soudure (20) assurant les connexions électriques respectives entre les parois conductrices (18) des rainures (17) et les parties saillantes (5A) desdits contacts (5) dudit second dispositif électronique (3).

7. Procédé de réalisation d'un dispositif d'interconnexion (1) entre un premier dispositif électronique (2), tel qu'un microprocesseur, et un second dispositif électronique (3), tel qu'une carte mère, ce dispositif d'interconnexion (1) étant apte à porter l'un (2) desdits dispositifs électroniques et à être porté par l'autre (3) de ceux-ci, lesdits premier et second dispositifs électroniques (2 et 3) étant pourvus de pluralités de contacts respectifs (4 ou 5) positionnés selon des dispositions semblables, de sorte que, lorsque ledit premier dispositif électronique (2) est mis en place sur le second (3), chacun de ses contacts (4), qui sont périphériques, est en appui contre un contact (5) dudit second dispositif électronique (3), ledit dispositif d'interconnexion (1) étant apte à permettre de modifier ledit premier dispositif électronique (2) en évitant de modifier ledit second dispositif électronique (3) et comportant une plaquette de circuit imprimé (7) comprenant deux faces opposées (8 et 9) limitées par un chant périphérique (10), la première (8) desdites faces comportant une pluralité (11) de premiers contacts périphériques (12) aptes à coopérer respectivement avec lesdits contacts périphériques (4) dudit premier dispositif électronique (2), tandis que la seconde (9) desdites faces comporte une pluralité (14) de seconds contacts périphériques (15) aptes à coopérer respectivement avec lesdits contacts (5) prévus sur ledit second dispositif électronique (3), lesdits premiers et seconds contacts périphériques (12 et 15) portés par lesdites faces opposées (8 et 9) de ladite plaquette (7) étant interconnectés,
**caractérisé :**
- **en ce que**, sur lesdites première et seconde faces (8 et 9) de ladite plaquette (7), on réalise respectivement lesdits premiers et seconds contacts périphériques (12, 15) sous la forme de plages électriquement conductrices ;
- **en ce que**, dans chacun desdits seconds contacts périphériques (15), on perce un trou cylindrique (23) traversant ladite plaquette (7) ;
- **en ce qu'**on revêt la paroi desdits trous cylindriques (23) d'une couche électriquement conductrice (24) ;
- **en ce qu'**on élimine la bordure périphérique (25) de ladite plaquette (7), de façon que chacun des trous (23) à paroi électriquement conductrice (24) devienne une rainure à paroi conductrice (17) de forme au moins approximativement hémicylindrique ; et
- **en ce qu'**on pratique un chanfrein (19) à la périphérie de ladite plaquette (7), entre ledit chant (10) et ladite première face (8), pour éliminer toute possibilité de contact entre lesdites rainures à paroi conductrice (17) et lesdits premiers contacts périphériques (12).

## Patentansprüche

1. Vorrichtung zur Verbindung (1) zwischen einer ersten elektronischen Anordnung (2), beispielsweise einem Mikroprozessor, und einer zweiten elektronischen Anordnung (3), beispielsweise einer Hauptplatine, wobei diese Verbindungsvorrichtung (1) die eine (2) der elektronischen Anordnungen trägt und ihrerseits von der anderen (3) der elektronischen Anordnungen getragen wird, wobei die erste und zweite elektronische Anordnung (2 und 3) mit einer Vielzahl von entsprechenden Kontakten (4 oder 5) versehen sind, die in ähnlicher Verteilung positioniert sind, so dass, wenn die erste elektronische Anordnung (2) auf die zweite (3) aufgelegt wird, jeder ihrer Kontakte (4), die peripher ausgebildet sind, an einem Kontakt (5) der zweiten elektronischen Anordnung (3) anliegt,
wobei die Verbindungsvorrichtung (1) dazu geeignet ist zu erlauben, die erste elektronische Anordnung (2) zu modifizieren, ohne dabei Änderungen an der zweiten elektronischen Anordnung (3) vorzunehmen, und eine Leiterplatte (7) aufweist, die zwei einander gegenüberliegende Seiten (8 und 9) aufweist, die von einer peripheren Schmalseite (10) begrenzt werden, wobei die erste (8) der Seiten eine Vielzahl (11) von ersten peripheren Kontakten (12) aufweist, die dazu geeignet sind, mit den jeweiligen peripheren Kontakten (4) der elektronischen Anordnung (2) zu kooperieren, während die zweite (9) der Seiten eine Vielzahl (14) von zweiten peripheren Kontakten (15) aufweist, die dazu geeignet sind, mit den jeweiligen Kontakten (5) zu kooperieren, die auf der zweiten elektronischen Anordnung (3) vorgesehen sind, wobei die ersten und zweiten peripheren Kontakte (12 und 15), die von den einander gegenüberliegenden Seiten (8 und 9) der Leiterplatte (7) getragen werden, miteinander verbunden sind;
- die zweiten peripheren Kontakte (15), die geeignet sind, mit den Kontakten (5) der zweiten elektronischen Anordnung (3) zu kooperieren, von elektrisch leitenden Bereichen gebildet werden, die von der zweiten Seite (9) getragen werden;
- jedem der zweiten peripheren Kontakte (15) eine Nut (17) mit einer leitenden Wand (18) zugeordnet ist, die in der Schmalseite (10) der Leiterplatte (7) ausgebildet ist und mit dem zugehörigen zweiten Kontakt (15) elektrisch verbunden ist;
- die Nuten (17) mit leitender Wand (18) von den ersten peripheren Kontakten (12) der ersten Seite (8) elektrisch isoliert sind;
- jeder der zweiten peripheren Kontakte (15) an den entsprechenden Kontakt (5) der zweiten elektronischen Anordnung (3) angelegt wird; und
- die Befestigung der Verbindungsvorrichtung (1) auf der zweiten elektronischen Anordnung (3) sowie die elektrische Leitung zwischen jedem der zweiten peripheren Kontakte (15) und dem entsprechenden Kontakt (5) der zweiten elektronischen Anordnung (3) mit Hilfe der Nuten (17) mit leitender Wand (18) realisiert wird.

2. Vorrichtung zur Verbindung nach Anspruch 1,
wobei die Nuten mit leitender Wand (17) eine Richtung aufweisen, die zumindest im Wesentlichen orthogonal zu den Seiten (8 und 9) der Leiterplatte (7) ist.

3. Vorrichtung zur Verbindung nach einem der Ansprüche 1 oder 2,
wobei die Nuten mit leitender Wand (17) durch eine periphere Fase (19) von den ersten peripheren Kontakten (12) elektrisch isoliert sind.

4. Vorrichtung zur Verbindung nach einem der Ansprüche 1 bis 3,
wobei jede der Nuten mit leitender Wand (17) eine Form aufweist, die zumindest annähernd halbzylindrisch ist.

5. Vorrichtung zur Verbindung nach einem der Ansprüche 1 bis 4,
wobei die Leiterplatte (7) eine mehrschichtige gedruckte Schaltung umfasst.

6. Verfahren zur Verbindung zwischen einer ersten elektronischen Anordnung (2), beispielsweise einem Mikroprozessor, und einer zweiten elektronischen Anordnung (3), beispielsweise einer Hauptplatine (3), mit Hilfe einer Verbindungsvorrichtung (1), welche die eine (2) der elektronischen Anordnungen trägt und ihrerseits von der anderen der elektronischen Anordnungen getragen wird, wobei die erste und zweite elektronische Anordnung (2 und 3) mit einer Vielzahl von entsprechenden Kontakten (4 oder 5) versehen sind, die in ähnlicher Verteilung positioniert sind, so dass, wenn die erste elektronische Anordnung (2) auf die zweite (3) aufgelegt wird, jeder ihrer Kontakte (4), die peripher ausgebildet sind, an einem Kontakt (5) der zweiten elektronischen Anordnung (3) anliegt,
wobei die Verbindungsvorrichtung (1) dazu geeignet ist zu erlauben, die erste elektronische Anordnung (2) zu modifizieren, ohne dabei Änderungen an der zweiten elektronischen Anordnung (3) vorzunehmen, und eine Leiterplatte (7) aufweist, die zwei einander gegenüberliegende Seiten (8 und 9) aufweist, die von einer peripheren Schmalseite (10) begrenzt werden, wobei die erste (8) der Seiten eine Vielzahl (11) von ersten peripheren Kontakten (12) aufweist, die dazu geeignet sind, mit den jeweiligen peripheren Kontakten (4) der elektronischen Anordnung (2) zu kooperieren, während die zweite (9) der Seiten eine Vielzahl (14) von zweiten peripheren Kontakten (15) aufweist, die dazu geeignet sind, mit den jeweiligen Kontakten (5) zu kooperieren, die auf der zweiten elektronischen Anordnung (3) vorgesehen sind, wobei die ersten und zweiten peripheren Kontakte (12 und 15), die von den einander gegenüberliegenden Seiten (8 und 9) der Leiterplatte (7) getragen werden, miteinander verbunden sind,
wobei:
- man die zweiten peripheren Kontakte (15) der Verbindungsvorrichtung (1) und die Kontakte (5) der zweiten elektronischen Anordnung (3) in Form von leitenden Bereichen ausführt, wobei die Kontakte (5) der zweiten elektronischen Anordnung (3) über den Außenrand der Leiterplatte (7) hinausragen (5A), wenn sich diese in ihrer Position auf der zweiten elektronischen Anordnung (3) befindet;
- man in der Schmalseite (10) der Leiterplatte (7) Nuten (17) mit leitender Wand (18) ausbildet, von denen jede einem der zweiten peripheren Kontakte (15) zugeordnet und mit ihm elektrisch verbunden ist, aber von den ersten peripheren Kontakten (12) elektrisch isoliert ist;
- man die zweite Seite (9) der Leiterplatte (7) so an die zweite elektronische Anordnung (3) anlegt, dass jeder der zweiten peripheren Kontakte (15) an einem Kontakt (5) der zweiten elektronischen Anordnung (3) anliegt; und
- man die Verbindungsvorrichtung (1) mit Hilfe von Lötstellen (20) auf der zweiten elektronischen Anordnung (3) befestigt, was die entsprechenden elektrischen Verbindungen zwischen den leitenden Wänden (18) der Nuten (17) und den überstehenden Teilen (5A) der Kontakte (5) der zweiten elektronischen Anordnung (3) sicherstellt.

7. Verfahren zur Herstellung einer Vorrichtung zur Verbindung (1) zwischen einer ersten elektronischen Anordnung (2), beispielsweise einem Mikroprozessor, und einer zweiten elektronischen Anordnung (3), beispielsweise einer Hauptplatine (3), wobei diese Verbindungsvorrichtung (1) dazu geeignet ist, die eine (2) der elektronischen Anordnungen zu tragen und ihrerseits von der anderen (3) der elektronischen Anordnungen getragen zu werden, wobei die erste und zweite elektronische Anordnung (2 und 3) mit einer Vielzahl von entsprechenden Kontakten (4 oder 5) versehen sind, die in ähnlicher Verteilung positioniert sind, so dass, wenn die erste elektronische Anordnung (2) auf die zweite (3) aufgelegt wird, jeder ihrer Kontakte (4), die peripher ausgebildet sind, an einem Kontakt (5) der zweiten elektronischen Anordnung (3) anliegt, wobei die Verbindungsvorrichtung (1) dazu geeignet ist zu erlauben, die erste elektronische Anordnung (2) zu modifizieren, ohne dabei Änderungen an der zweiten elektronischen Anordnung (3) vorzunehmen, und eine Leiterplatte (7) aufweist, die zwei einander gegenüberliegende Seiten (8 und 9) aufweist, die von einer peripheren Schmalseite (10) begrenzt werden, wobei die erste (8) der Seiten eine Vielzahl (11) von ersten peripheren Kontakten (12) aufweist, die dazu geeignet sind, mit den jeweiligen peripheren Kontakten (4) der ersten elektronischen Anordnung (2) zu kooperieren, während die zweite (9) der Seiten eine Vielzahl (14) von zweiten peripheren Kontakten (15) aufweist, die dazu geeignet sind, mit den jeweiligen Kontakten (5) zu kooperieren, die auf der zweiten elektronischen Anordnung (3) vorgesehen sind, wobei die ersten und zweiten peripheren Kontakte (12 und 15), die von den einander gegenüberliegenden Seiten (8 und 9) der Leiterplatte (7) getragen werden, miteinander verbunden sind,
wobei man:
- die ersten beziehungsweise zweiten peripheren Kontakte (12, 15) auf der ersten und der zweiten Seite (8 und 9) der Leiterplatte (7) in Form von elektrisch leitenden Bereichen realisiert;
- in jeden der zweiten peripheren Kontakte (15) ein zylinderförmiges Loch (23) bohrt, das durch die Leiterplatte (7) hindurchgeht;
- auf der Wand der zylinderförmigen Bohrungen (23) eine elektrisch leitende Schicht (24) aufträgt;
- den Außenrand (25) der Leiterplatte (7) entfernt, so dass aus jeder der Bohrungen (23) mit elektrisch leitender Wand (24) eine Nut mit elektrisch leitender Wand (17) von zumindest annähernd halbzylindrischer Form wird; und
- am Rand der Leiterplatte (7), zwischen der Schmalseite (10) und der ersten Seite (8), eine Fase (19) macht, um jede Kontaktmöglichkeit zwischen den Nuten mit leitender Wand (17) und den ersten peripheren Kontakten (12) auszuschließen.

## Claims

1. Device (1) for interconnection between a first electronic device (2), such as a microprocessor, and a second electronic device (3), such as a motherboard, this interconnection device (1) supporting one (2) of said electronic devices and being supported by the other (3) of said electronic devices, said first and second electronic devices (2 and 3) being provided with pluralities of respective contacts (4 or 5) that are positioned in similar arrangements, so that, when said first electronic device (2) is placed on the second electronic device (3), each of its contacts (4), which are peripheral, bears against a contact (5) of said second electronic device (3), said interconnection device (1) being capable of allowing said first electronic device (2) to be modified while avoiding having to modify said second electronic device (3), and having a printed circuit card (7) comprising two opposite faces (8 and 9) bounded by a peripheral edge (10), the first (8) of said faces having a plurality (11) of first peripheral contacts (12) which can engage respectively with said peripheral contacts (4) of said electronic device (2), while the second (9) of said faces has a plurality (14) of second peripheral contacts (15) which can engage respectively with said contacts (5) that are provided on said second electronic device (3), said first and second peripheral contacts (12 and 15) which are carried by said opposite faces (8 and 9) of said card (7) being interconnected;
- said second peripheral contacts (15), which can engage with the contacts (5) of said second electronic device (3), consist of electrically conductive zones carried by said second face (9);
- a groove (17) with a conductive wall (18), made in said edge (10) of the card (7) and in electrical connection with said associated second contact (15), is associated with each of said second peripheral contacts (15);
- said grooves (17) with conductive walls (18) are electrically insulated from said first peripheral contacts (12) of said first face (8);
- each of said second peripheral contacts (15) is applied against the corresponding contact (5) of said second electronic device (3); and
- the fastening of said interconnection device (1) on said second electronic device (3), as well as the electrical conduction between each of said second peripheral contacts (15) and the corresponding contact (5) of said second electronic device (3) are obtained by means of said grooves (17) with conductive walls (18).

2. Interconnection device according to Claim 1, **characterized in that** said grooves (17) with conductive walls have a direction at least substantially orthogonal to said faces (8 and 9) of said card (7).

3. Interconnection device according to either of Claims 1 and 2, **characterized in that** said grooves (17) with conductive walls are electrically insulated from said first peripheral contacts (12) by a peripheral chamfer (19).

4. Interconnection device according to one of Claims 1 to 3, **characterized in that** each of said grooves (17) with conductive walls has an at least approximately semicylindrical shape.

5. Interconnection device according to Claims 1 to 4, **characterized in that** said card (7) comprises a multilayer printed circuit.

6. Process for interconnection between a first electronic device (2), such as a microprocessor, and a second electronic device (3), such as a motherboard, by means of an interconnection device (1) supporting one (2) of said electronic devices and being supported by the other (3) of said electronic devices, said first and second electronic devices (2 and 3) being provided with pluralities of respective contacts (4 or 5) that are positioned in similar arrangements, so that, when said first electronic device (2) is placed on the second electronic device (3), each of its contacts (4), which are peripheral, bears against a contact (5) of said second electronic device (3), said interconnection device (1) being capable of allowing said first electronic device (2) to be modified while avoiding having to modify said second electronic device (3), and having a printed circuit card (7) comprising two opposite faces (8 and 9) bounded by a peripheral edge (10), the first (8) of said faces having a plurality (11) of first peripheral contacts (12) which can engage respectively with said peripheral contacts (4) of said first electronic device (2), while the second (9) of said faces has a plurality (14) of second peripheral contacts (15) which can engage respectively with said contacts (5) that are provided on said second electronic device (3), said first and second peripheral contacts (12 and 15) which are carried by said opposite faces (8 and 9) of said card (7) being interconnected, **characterized in that**:
- said second peripheral contacts (15) of the interconnection device (1) and said contacts (5) of said second electronic device (3) are produced in the form of conductive zones, said contacts (5) of said second electronic device (3) protruding (5A) outside the contour of said card (7) when the latter is in position on said second electronic device (3);
- grooves (17) with conductive walls (18) are formed in the edge (10) of said card (7), each of which is associated and in electrical connection with one of said second peripheral contacts (15) but is electrically insulated from said first peripheral contacts (12);
- said second face (9) of said card (7) is applied against said second electronic device (3) so that each of said second peripheral contacts (15) is applied on a contact (5) of said second electronic device (3); and
- said interconnection device (1) is fixed on said second electronic device (3) by portions of solder (20) which make the respective electrical connections between the conductive walls (18) of the grooves (17) and the protruding parts (5A) of said contacts (5) of said second electronic device (3).

7. Process for producing a device (1) for interconnection between a first electronic device (2), such as a microprocessor, and a second electronic device (3), such as a motherboard, this interconnection device (1) being capable of supporting one (2) of said electronic devices and of being supported by the other (3) of said electronic devices, said first and second electronic devices (2 and 3) being provided with pluralities of respective contacts (4 or 5) that are positioned in similar arrangements, so that, when said first electronic device (2) is placed on the second electronic device (3), each of its contacts (4), which are peripheral, bears against a contact (5) of said second electronic device (3), said interconnection device (1) being capable of allowing said first electronic device (2) to be modified while avoiding having to modify said second electronic device (3), and having a printed circuit card (7) comprising two opposite faces (8 and 9) bounded by a peripheral edge (10), the first (8) of said faces having a plurality (11) of first peripheral contacts (12) which can engage respectively with said peripheral contacts (4) of said first electronic device (2), while the second (9) of said faces has a plurality (14) of second peripheral contacts (15) which can engage respectively with said contacts (5) that are provided on said second electronic device (3), said first and second peripheral contacts (12 and 15) which are carried by said opposite faces (8 and 9) of said card (7) being interconnected, **characterized in that**:
- said first and second peripheral contacts (12, 15) are respectively produced, on said first and second faces (8 and 9) of said card (7), in the form of electrically conductive zones;
- a cylindrical hole (23) which passes through said card (7) is pierced in each of said second peripheral contacts (15);
- the wall of said cylindrical holes (23) is covered with an electrically conductive layer (24);
- the peripheral border (25) of said card (7) is removed so that each of the holes (23) with electrically conductive walls (24) becomes a groove (17) with a conductive wall of at least approximately semicylindrical shape; and
- a chamfer (19) is made at the periphery of said card (7), between said edge (10) and said first face (8), in order to remove any possibility of contact between said grooves (17) with conductive walls and said first peripheral contacts (12).
